# EUROPÄISCHE PATENTSCHRIFT

(11) **EP 3 189 547 B1**
(45) Veröffentlichungstag und Bekanntmachung des Hinweises auf die Patenterteilung: **25.11.2020**
(21) Anmeldenummer: 15747479.2
(22) Anmeldetag: 05.08.2015
(51) Int. Cl.: H01L 25/16, H01L 33/48

(54) **LEUCHTDIODENVORRICHTUNG**
LIGHT-EMITTING DIODE DEVICE
DISPOSITIF À DIODE ÉLECTROLUMINESCENTE

(30) Priorität: 03.09.2014 DE 102014112673
(43) Veröffentlichungstag der Anmeldung: 12.07.2017
(73) Patentinhaber: TDK Electronics AG, 81671 München (DE)
(72) Erfinder: FEICHTINGER, Thomas, A-8010 Graz (AT); DERNOVSEK, Oliver, A-8501 Lieboch (AT)
(74) Vertreter: Epping - Hermann - Fischer
(86) Internationale Anmeldenummer: PCT/EP2015/068074
(87) Internationale Veröffentlichungsnummer: WO 2016/034359

(56) Entgegenhaltungen:
- WO-A1-2013/084437
- DE-A1- 10 026 460
- DE-A1-102012 108 107
- JP-A- 2007 329 249
- US-A1- 2003 179 548

## Beschreibung

Es wird eine Leuchtdiodenvorrichtung angegeben, die zumindest einen Träger und eine auf dem Träger angeordneten Leuchtdiode aufweist.

Beim Design von Systemen mit Leuchtdioden (LEDs) spielen Lichtausbeute, Lebensdauer und thermisches Management eine immer wichtigere Rolle. Neben funktionalen Herausforderungen gibt es auch thermomechanische und geometrische Probleme zu lösen. LEDs sind sensitiv gegenüber Übertemperaturen, beispielsweise Temperaturen über 135°C-150°C, und elektrostatische Entladungen, beispielsweise Spannungen über 100 V. Speziell bei mobilen Anwendungen, beispielsweise für einen integrierten LED-Kamerablitz in Smartphones oder Digitalkameras, sollen die LED sowie diskrete Schutzbauelemente eine möglichst geringe Bauhöhe aufweisen und möglichst wenig Platz einnehmen. Eine weitere wichtige Anforderung an die Gehäuselösung liegt darin, dass die Abschattung der LED durch andere Bauelemente, beispielsweise Schutzbauelementen, möglichst gering sein sollte.

Aus der deutschen Patentanmeldung DE 102012108107 A1 geht eine Leuchtdiodenvorrichtung hervor. Die DE 100 26 460 A1 beschreibt eine Anschlussvorrichtung für Leuchtdioden, bei der in einer flexiblen Trägerlage Leiterbahnen und ein Vorwiderstand eingebettet sind. Die US 2003/179548 A1 beschreibt eine Anschlussstruktur mit mehreren Polymerschichten. Die DE 10 2012 108 107 A1 beschreibt eine Leuchtdiodenvorrichtung, bei der ein ESD-Schutzelement in einen Träger eingebettet ist. Die WO 2013/084437 A1 und JP 2007 329249 A offenbaren jeweils eine Leuchtdiodenvorrichtung, bei der eine Zenerdiode in einen Träger eingebettet ist.

Es ist eine Aufgabe der vorliegenden Erfindung, eine verbesserte Leuchtdiodenvorrichtung anzugeben.

Gemäß einem ersten Aspekt der vorliegenden Erfindung wird eine Leuchtdiodenvorrichtung angegeben. Die Leuchtdiodenvorrichtung weist wenigstens einen Träger und wenigstens eine auf dem Träger angeordnete Leuchtdiode, insbesondere in Form eines Leuchtdiodenchips, auf. Der Träger weist mehrere übereinander angeordnete Polymerschichten auf. In wenigstens eine Polymerschicht ist ein elektrisches Bauelement eingebettet. Beispielsweise weist die Polymerschicht eine Aussparung auf, in die das Bauelement eingebettet ist. Dabei kann das elektrische Bauelement vollständig oder auch nur teilweise in die Polymerschicht eingebettet sein.

In einer Ausführungsform weist der Träger eine oberste, eine unterste und wenigstens eine dazwischen angeordnete innere Polymerschicht aufweist, wobei das elektrische Bauelement zumindest in der inneren Polymerschicht eingebettet ist. Zur elektrischen Kontaktierung des elektrischen Bauelements ist beispielsweise wenigstens eine Durchkontaktierung vorgesehen, die durch wenigstens eine Polymerschicht hindurchführt.

Die LED ist vorzugsweise auf der obersten Polymerschicht angeordnet. Beispielsweise sind auf der obersten Polymerschicht obere Anschlusskontakte vorgesehen, an der die LED befestigt und/oder elektrisch angeschlossen ist. Beispielsweise sind an der Unterseite der untersten Polymerschicht untere Anschlusskontakte zur Weiterkontaktierung der LED vorgesehen. Beispielsweise führt wenigstens eine Durchkontaktierung durch den Träger hindurch, um die oberen Anschlusskontakte mit den unteren Anschlusskontakten elektrisch zu verbinden. Die LED kann zumindest teilweise in einer Kavität im Träger, insbesondere in einer Kavität an einer Oberseite des Trägers, versenkt sein.

Zwischen der obersten und untersten Polymerschicht können auch mehrere innere Polymerschichten angeordnet sein. Das elektrische Bauelement kann vollständig oder auch nur teilweise in eine oder mehrere der inneren Polymerschichten eingebettet sein. In einer Ausführungsform ist das Bauelement weder in die oberste noch in die unterste Polymerschicht eingebettet. Insbesondere ist das Bauelement auch nicht teilweise in die oberste oder unterste Polymerschicht eingebettet. Beispielsweise führen jedoch Durchkontaktierungen durch die oberste und/oder unterste Polymerschicht hindurch.

Eine Anordnung des Bauelements in einer oder mehreren inneren Polymerschichten, insbesondere im Kern des Trägers, erlaubt einen besonders guten Abbau thermischer Spannungen. Auf diese Weise kann die Lebensdauer der Vorrichtung erhöht werden.

In einer Ausführungsform ist das Bauelement vollständig im Inneren des Trägers angeordnet. Insbesondere ist das Bauelement auf allen Seiten vom Polymermaterial des Trägers umgeben. Dabei ist aber auch der Fall eingeschlossen, dass Durchkontaktierungen vom Bauelement durch das Polymermaterial führen.

In einer Ausführungsform weisen die ein oder mehreren Polymerschichten, in die das Bauelement eingebettet ist, andere Materialeigenschaften auf als wenigstens eine andere Polymerschicht des Trägers. Beispielsweise handelt es sich um eine innere Polymerschicht, die sich in ihren Materialeigenschaften von der obersten und/oder untersten Polymerschicht des Trägers unterscheidet.

Erfindungsgemäß unterscheiden sich die Polymerschichten in ihrer mechanischen Festigkeit voneinander. Erfindungsgemäß weist die Polymerschicht, in die das Bauelement eingebettet ist, eine geringere mechanische Festigkeit auf als eine andere Polymerschicht des Trägers. Die jeweiligen Festigkeiten können je nach gewünschter Steifigkeit und/oder Verbiegbarkeit des Trägers gewählt werden.

In einer Ausführungsform ist das elektrische Bauelement zum Schutz vor elektrischen Entladungen (ESD-Schutz) ausgebildet. Beispielsweise ist das Bauelement als Varistor, als Silizium-Halbleiter-Schutzdiode oder als Polymer-Bauteil ausgebildet. In einer weiteren Ausführungsform ist das elektrische Bauelement als thermischer Sensor, als Überstromschutz, als keramischer Vielschichtkondensator, als Induktivität und/oder als Widerstand ausgebildet. In einer weiteren Ausführungsform ist das elektrische Bauelement als Treiberchip ausgebildet. Im Träger können auch mehrere elektrische Bauelemente, insbesondere eine Kombination unterschiedlicher Bauelement eingebettet sein. In einer Ausführungsform sind alle eingebetteten elektrischen Bauelemente in einer oder mehreren inneren Polymerschichten eingebettet. Beispielsweise sind alle Bauelemente in dieselben ein oder mehreren Polymerschichten eingebettet.

Das elektrische Bauelement ist in lateraler Richtung zentriert bezüglich der LED angeordnet. Insbesondere befindet sich das elektrische Bauelement bei einer Aufsicht auf die LED direkt unterhalb der LED. Dies ermöglicht beispielsweise eine besonders platzsparende Anordnung des Bauelements. Beispielsweise ist das Bauelement als Temperatursensor angeordnet. Bei einer Anordnung zentriert bezüglich der LED ist eine besonders zuverlässige Temperaturerfassung am Ort der LED möglich. Die thermische Anbindung an die LED kann beispielsweise mit einer thermischen Via verbessert werden.

In einer Ausführungsform ist das elektrische Bauelement bezüglich einer Stapelrichtung der Polymerschichten zentriert im Träger angeordnet. Insbesondere ist das Bauelement im Kern des Trägers angeordnet. Beispielsweise befinden sich oberhalb und unterhalb des Bauelements ähnlich oder gleich viele Polymerschichten. Durch eine derartige Anordnung lässt sich das thermische Management optimieren. Insbesondere können thermische Spannungen besonders gut ausgeglichen werden.

Die Leuchtdiodenvorrichtung kann auch mehrere LEDs aufweisen, die auf dem Träger angeordnet sind. Jeder LED können ein oder mehrere elektrische Bauelemente zugeordnet sein, die im Träger eingebettet sind. Beispielsweise ist jeder LED ein ESD-Schutzbauelement und/oder ein Temperatursensor zugeordnet. Beispielsweise ist wenigstens unterhalb jeder LED ein Bauelement, insbesondere ein der LED zugeordnetes Bauelement, im Träger eingebettet.

In einer Ausführungsform ist die Leuchtdiode direkt auf dem Träger aufweisend die Polymerschichten angeordnet. In einer anderen Ausführungsform weist die Leuchtdiodenvorrichtung einen weiteren Träger auf, auf dem die Leuchtdiode angeordnet ist. Der weitere Träger ist auf dem Träger aufweisend die Polymerschichten angeordnet. Beispielsweise handelt es sich bei dem weiteren Träger um einen keramischen Träger.

Im Folgenden werden die hier beschriebenen Gegenstände anhand von schematischen und nicht maßstabsgetreuen Ausführungsbeispielen näher erläutert.

Es zeigen:

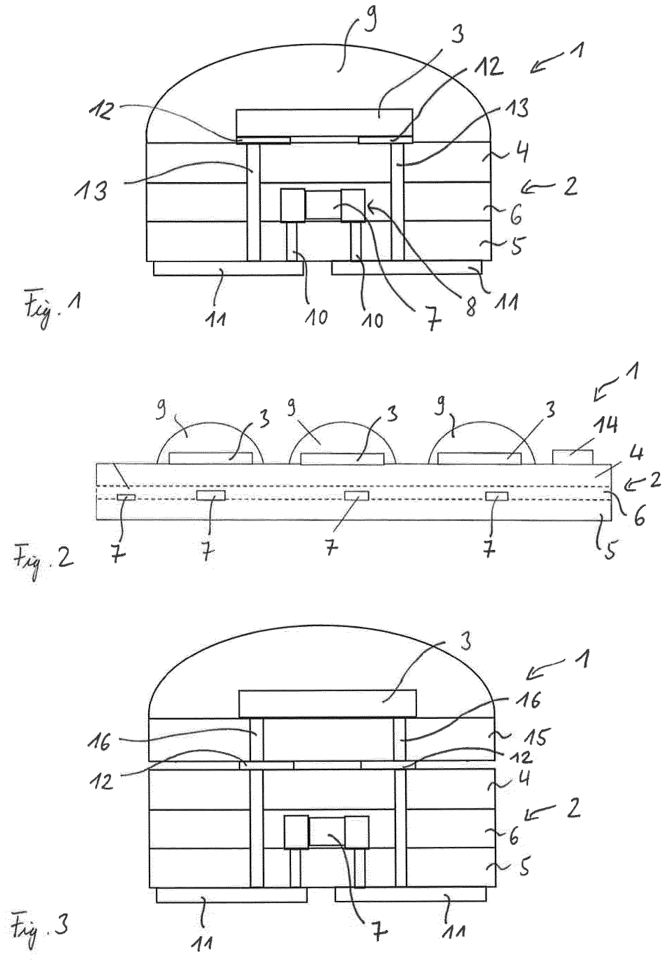

- Figuren 1 bis 5: in schematischen Schnittansichten mehrere Ausführungsbeispiele von Leuchtdiodenvorrichtungen aufweisend wenigstens einen Träger mit wenigstens einer darauf angeordneten LED.

Vorzugsweise verweisen in den folgenden Figuren gleiche Bezugszeichen auf funktionell oder strukturell entsprechende Teile der verschiedenen Ausführungsformen.

Figur 1 zeigt eine Leuchtdiodenvorrichtung 1 aufweisend einen Träger 2 für eine Leuchtdiode (LED) 3. Die LED 3 ist in Form eines Leuchtdiodenchips ausgebildet und auf einer Oberseite des Trägers 2 angeordnet. In einer Ausführungsform kann die LED 3 auch teilweise in einer Kavität im Träger 2 versenkt sein.

Der Träger 2 weist mehrere übereinander angeordnete, laminierte Polymerschichten 4, 5, 6 auf. Beispielsweise weisen die Polymerschichten 4, 5, 6 ein Epoxidmaterial auf. Insbesondere weist der Träger 2 eine oberste Polymerschicht 4, eine unterste Polymerschicht 5 und wenigstens eine dazwischen angeordnete innere Polymerschicht 6 auf. Der Träger 2 kann auch mehrere innere Polymerschichten 6 aufweisen.

In der inneren Polymerschicht 6 ist ein elektrisches Bauelement 7 eingebettet. Insbesondere weist die innere Polymerschicht 6 eine Aussparung 8 auf, in der das Bauelement 7 angeordnet ist. Somit ist das Bauelement 7 in den Träger 2 integriert. Beispielsweise ist das Bauelement 7 direkt unterhalb der LED 3 angeordnet. Dies ermöglicht eine besonders platzsparende Anordnung.

Hierbei kann es vorteilhaft sein, wenn das elektrische Bauelement 7 zentriert im Träger 2 angeordnet ist. Beispielsweise befinden sich genauso viele oder ähnlich viele Polymerschichten 4, 5 oberhalb wie unterhalb der Polymerschicht 6, in der das Bauelement 7 eingebettet ist. In diesem Fall ist das Bauelement 7 zentriert bezüglich einer Stapelrichtung der Polymerschichten 4, 5, 6 angeordnet. Alternativ oder zusätzlich dazu kann das Bauelement 7 auch in lateraler Richtung zentriert, beispielsweise bezüglich der LED 3, angeordnet sein. Insbesondere kann das Bauelement 7 zentriert unterhalb der LED 3 angeordnet sein. Bei einer derart zentrierten Anordnung könne Spannungen besonders gleichmäßig verteilt und ausgeglichen werden.

In einer Ausführungsform ist das elektrische Bauelement 7 als Schutzbauelement, beispielsweise zum Schutz vor elektrostatischen Entladungen (ESD), Überströmen und/oder erhöhten Betriebstemperaturen ausgebildet. Beispielsweise ist das ESD-Schutzbauelement als Varistor, insbesondere als Multilagen-Varistor, als Silizium-Halbleiter-Schutzdiode, insbesondere als TVS-Diode oder als Polymer-Bauteil ausgebildet. Alternativ ist das elektrische Bauelement 7 beispielsweise als thermischer Sensor, insbesondere als NTC-Sensor, als Überstromschutz, insbesondere als PTC-Überstromschutz, als keramischer Vielschichtkondensator, insbesondere als MLCC-Bauteil, als Induktivität und/oder als Widerstand ausgebildet. Alternativ ist das Bauelement 7 als Treiberchip ausgebildet. Vorzugsweise ist das Bauelement 7 mit der LED 3 elektrisch verschaltet. Es können auch mehrere elektrische Bauelemente 7, beispielsweise wenigstens ein ESD-Schutzbauelement und ein Temperatursensor in den Träger 2 integriert sein.

Vorzugsweise ist das Bauelement 7 ultradünn ausgebildet. Beispielsweise weist es eine Dicke von 0,3 mm oder weniger auf.

Erfindungsgemäß ist die mechanische Festigkeit der Polymerschicht 6, in die das Bauelement 7 eingebettet ist, geringer als die mechanische Festigkeit wenigstens einer anderen Polymerschichten 4, 5. Beispielsweise ist die innere Polymerschicht 6 leichter mechanisch verformbar als die oberste und die unterste Polymerschicht 4, 5. Auf diese Weise können beispielsweise thermische Spannungen im Kern des Trägers 2 ausgeglichen werden.

Das elektrische Bauelement 7 ist mittels Durchkontaktierungen 10 elektrisch kontaktiert. Die Durchkontaktierungen 10 führen durch die unterste Schicht 5 hindurch und sind jeweils mit einem flächigen Anschlusskontakt 11 verbunden, der auf einer Unterseite des Trägers 2 angeordnet ist. Die LED 3 ist auf oberen Anschlusskontakten 12 angeordnet, die auf einer Oberseite des Trägers 2 angeordnet sind. Die oberen Anschlusskontakte 12 sind mit weiteren Durchkontaktierungen 13 verbunden, die durch den gesamten Träger 2 hindurchführen und eine elektrische Verbindung zu den Anschlusskontakten 11 an der Unterseite 2 des Trägers bereitstellen. Das elektrische Bauelement 7 und die damit verbundenen Durchkontaktierungen 10 sind in der Schnittansicht innerhalb eines Raumes angeordnet, der seitlich von den weiteren Durchkontaktierungen 13 begrenzt ist.

Die LED 3 ist von einer Schutzbeschichtung 9 umschlossen. Die Schutzbeschichtung 9 wirkt beispielsweise als Linse. Die Schutzbeschichtung 9 weist beispielsweise Silikon und optional eine Phosphorschicht auf.

Zur Herstellung der Leuchtdiodenvorrichtung 1 werden beispielsweise mehrere Polymerschichten 4, 5, 6 bereitgestellt, wobei wenigstens eine Polymerschicht 6 eine Aussparung 8 aufweist. Die Polymerschichten 4, 5, 6 werden übereinander angeordnet, wobei dabei ein elektrisches Bauelement 7 in der Aussparung 8 angeordnet wird. Der Stapel aus Polymerschichten 4, 5, 6 enthaltend das eingebettete Bauelement 7 wird zu einem Laminat verpresst.
Zur Ausbildung der Durchkontaktierungen 10, 13 werden beispielsweise nach dem Verpressen Löcher, z. B. mittels eines Lasers, in die Polymerschichten 4, 5, 6 eingebracht. Die Löcher werden mit einem elektrisch leitfähigen Material, beispielsweise in einem galvanischen Verfahren oder in einem stromlosen elektrochemischen Verfahren aufgefüllt. Beispielsweise werden die Löcher mit Kupfer aufgefüllt. Anschließend werden die Anschlusskontakte 10, 12 ausgebildet. Anschließend wird die LED 3 auf die oberen Anschlusskontakte 12 aufgesetzt und beispielsweise durch Bonden oder Löten befestigt. Die LED 3 wird mit der Schutzbeschichtung 9 versehen.
Figur 2 zeigt eine weitere Ausführungsform einer Leuchtdiodenvorrichtung 1, bei der mehrere LEDs 3 mit jeweiligen Schutzbeschichtungen 9 auf einem gemeinsamen Träger 2 aufweisend laminierte Polymerschichten 4, 5, 6 angeordnet sind.

Es sind mehrere elektrische Bauelemente 7 in den Träger 2 eingebettet. Beispielsweise ist jeder LED 3 wenigstens ein Bauelement 7 zugeordnet. Das jeweils zugeordnete Bauelement 7, beispielsweise in Form eines ESD-Schutzbauelements, kann direkt unterhalb der zugeordneten LED 3 angeordnet sein.

Zudem ist auf dem Träger 2 ein weiteres elektrisches Bauelement 14 angeordnet. Das weitere Bauelement 14 ist nicht im Träger 2 eingebettet. Das weitere Bauelement 14 kann alternativ in einer Vertiefung im Träger 2 teilweise oder vollständig versenkt sein. Beispielsweise ist das weitere Bauelement 14 auf einer Oberseite des Trägers 2 angeordnet, auf der auch die LEDs 3 angeordnet sind.

Beispielsweise ist das weitere elektrische Bauelement 14 als thermischer Sensor ausgebildet. Insbesondere kann es sich um ein Thermistorelement, beispielsweise um ein NTC- oder PTC-Thermistorelement handeln.

Die Leuchtdiodenvorrichtung 1 kann ansonsten wie zu Figur 1 beschrieben ausgebildet sein.

Figur 3 zeigt eine weitere Ausführungsform einer Leuchtdiodenvorrichtung 1, wobei hier ein weiterer Träger 15 vorgesehen ist, auf dem die LED 3 angeordnet ist. Der weitere Träger 15 weist beispielsweise einen keramischen Grundkörper auf. Der keramische Grundkörper kann mehrschichtig ausgebildet sein.

Der weitere Träger 15 ist auf dem Träger 2 aufweisend die Polymerschichten 4, 5, 6 angeordnet. Insbesondere ist der weitere Träger 15 an oberen Anschlusskontakten 12 des Trägers 2 befestigt und mit diesen elektrisch verbunden. Die LED 3 ist mit Durchkontaktierungen 16 verbunden, die durch den weiteren Träger 15 hindurchführen und mit den Anschlusskontakten 12 elektrisch verbunden sind.

Die Leuchtdiodenvorrichtung 1 kann ansonsten wie zu den Figuren 1 und 2 beschrieben ausgebildet sein.

Eine Anordnung, bei dem ein oder mehrere LEDs und/oder andere Bauelemente auf einem einzigen Träger angeordnet sind (Figuren 1 und 2) wird als Level 1-System bezeichnet. Werden ein oder mehrere Level 1 - Systeme wiederum auf einem gemeinsamen Träger montiert spricht man von einem Level 2 - System, wie in Figur 3 gezeigt. Ein Level 2 - System kann insbesondere mehrere Level 1 - Module enthalten.

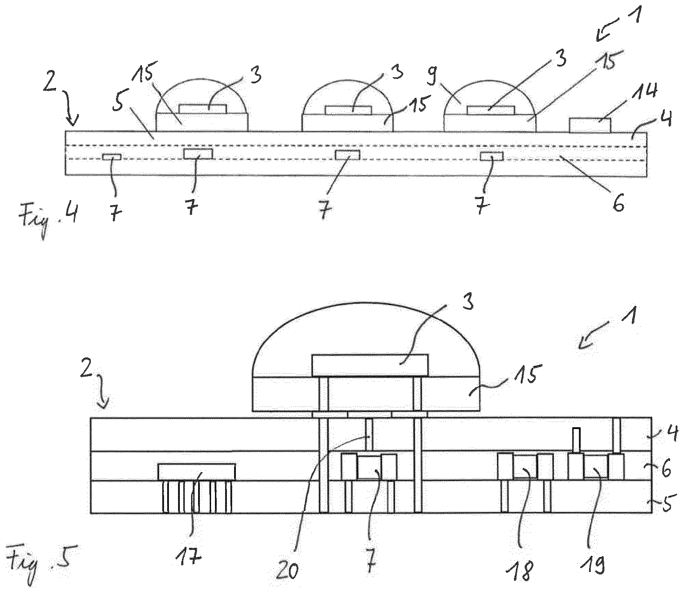

Figur 4 zeigt eine weitere Ausführungsform einer Leuchtdiodenvorrichtung 1, wobei hier mehrere LEDs 3 vorgesehen sind, die jeweils auf einem weiteren Träger 15 angeordnet sind.

Die weiteren Träger 15 sind auf einem gemeinsamen Träger 2 angeordnet. Der gemeinsame Träger 2 weist Polymerschichten 4, 5, 6 auf, in die mehrere elektrische Bauelemente 7 eingebettet sind. Zudem sind auf dem Träger 2 ein oder mehrere weitere elektrische Bauelemente 14 angeordnet.

Die Leuchtdiodenvorrichtung 1 kann ansonsten wie zu den Figuren 1 bis 3 beschrieben ausgebildet sein.

Figur 5 zeigt eine weitere Ausführungsform einer Leuchtdiodenvorrichtung 1, das ähnlich wie die Leuchtdiodenvorrichtung 1 aus Figur 3 ausgebildet ist, wobei hier mehrere elektrische Bauelemente 7, 17, 18, 19 in den Träger 2 integriert sind.

Insbesondere sind die Bauelemente 7, 17, 18, 19 in eine oder mehrere innere Polymerschichten 6 des Trägers 2 eingebettet. Beispielsweise sind alle Bauelemente 7, 17, 18, 19 in die gleiche Polymerschicht 6 eingebettet.

Beispielsweise ist eines der elektrischen Bauelemente 7 direkt unterhalb der LED 3 angeordnet. Beispielsweise handelt es sich hierbei um einen Temperatursensor, insbesondere um einen NTC- oder PTC-Thermistor. Beispielsweise ist eines der elektrischen Bauelemente 17 als keramischer Multilagenkondensator (MLCC), Widerstand und/oder Induktivität ausgebildet. Beispielsweise ist eines der elektrischen Bauelemente 18 als ESD-Schutzbauelement, insbesondere als Multilagenvaristor, ausgebildet. Beispielsweise ist eines der elektrischen Bauelemente 19 als LED-Treiberchip ausgebildet.

Zudem ist eine metallische Via 20 zur Verbesserung der thermischen Anbindung vorgesehen. Die metallische Via 20 führt durch die oberste Schicht 4 hindurch und ist direkt unterhalb des weiteren Trägers 15 angeordnet.

### Bezugszeichenliste

- 1: Leuchtdiodenvorrichtung
- 2: Träger
- 3: Leuchtdiode (LED)
- 4: oberste Schicht
- 5: unterste Schicht
- 6: innere Schicht
- 7: elektrisches Bauelement
- 8: Aussparung
- 9: Schutzbeschichtung
- 10: Durchkontaktierung
- 11: unterer Anschlusskontakt
- 12: oberer Anschlusskontakt
- 13: weitere Durchkontaktierung
- 14: weiteres elektrisches Bauelement
- 15: weiterer Träger
- 16: Durchkontaktierung
- 17: elektrisches Bauelement
- 18: elektrisches Bauelement
- 19: elektrisches Bauelement
- 20: thermische Via

## Patentansprüche

1. Leuchtdiodenvorrichtung, aufweisend wenigstens einen Träger (2) und wenigstens eine Leuchtdiode (3), die auf dem Träger angeordnet ist, wobei der Träger (2) mehrere übereinander angeordnete Polymerschichten (4, 5, 6) aufweist und wobei in wenigstens eine der Polymerschichten (4, 5, 6) ein elektrisches Bauelement (7, 17, 18, 19) eingebettet ist, bei der das elektrische Bauelement (7, 17, 18, 19) bezüglich einer lateralen Richtung zentriert bezüglich der Leuchtdiode (3) angeordnet ist,
**gekennzeichnet dadurch, dass** die Polymerschicht (6), in die das elektrische Bauelement (7, 17, 18, 19) eingebettet ist, leichter mechanisch verformbar ist als eine andere der Polymerschichten (4, 5).

2. Leuchtdiodenvorrichtung nach dem vorhergehenden Anspruch, bei der der Träger (2) eine oberste, eine unterste und wenigstens eine dazwischen angeordnete innere Polymerschicht (4, 5, 6) aufweist, wobei das elektrische Bauelement (7, 17, 18, 19) zumindest in die innere Polymerschicht (6) eingebettet ist.

3. Leuchtdiodenvorrichtung nach einem der vorhergehenden Ansprüche, bei der das elektrische Bauelement (7, 17, 18, 19) auf allen Seiten vom Polymermaterial des Trägers (2) umgeben ist.

4. Leuchtdiodenvorrichtung nach dem vorhergehenden Anspruch, bei der das Bauelement (2) weder in die oberste noch in die unterste Polymerschicht (4, 5) eingebettet ist.

5. Leuchtdiodenvorrichtung nach einem der vorhergehenden Ansprüche, aufweisend wenigstens eine Durchkontaktierung (10) zur elektrischen Kontaktierung des elektrischen Bauelements, wobei die Durchkontaktierung (10) durch wenigstens eine Polymerschicht (4, 5, 6) hindurchführt.

6. Leuchtdiodenvorrichtung nach einem der vorhergehenden Ansprüche, aufweisend wenigstens zwei Durchkontaktierungen (10) zur Verbindung des elektrischen Bauelements (7, 17, 18, 19) mit Anschlusskontakten (11) und aufweisend wenigstens zwei weitere Durchkontaktierungen (13) zur Verbindung der Leuchtdiode (3) mit den Anschlusskontakten (11), wobei die wenigstens zwei Durchkontaktierungen (10) zwischen den wenigstens zwei weiteren Durchkontaktierungen (13) angeordnet sind.

7. Leuchtdiodenvorrichtung nach einem der vorhergehenden Ansprüche, bei der das elektrische Bauelement(7, 18) zum Schutz vor elektrostatische Entladungen ausgebildet ist.

8. Leuchtdiodenvorrichtung nach einem der vorhergehenden Ansprüche, bei der das elektrische Bauelement (7, 17, 18) als Varistor, als Silizium-Halbleiter-Schutzdiode, als Polymer-Bauteil, als thermischer Sensor, als Überstromschutz, als keramischer Vielschichtkondensator, als Induktivität, als Widerstand oder als Treiberchip ausgebildet ist.

9. Leuchtdiodenvorrichtung nach einem der vorhergehenden Ansprüche, bei dem die Leuchtdiode (3) zumindest teilweise in einer Kavität im Träger (2) versenkt ist.

10. Leuchtdiodenvorrichtung nach einem der vorhergehenden Ansprüche, bei der das elektrische Bauelement (7, 17, 18, 19) bezüglich einer Stapelrichtung der Polymerschichten (4, 5, 6) zentriert im Träger (2) angeordnet ist.

11. Leuchtdiodenvorrichtung nach einem der vorhergehenden Ansprüche, aufweisend mehrere Leuchtdioden (3), die auf dem Träger (2) angeordnet sind.

12. Leuchtdiodenvorrichtung nach einem der vorhergehenden Ansprüche, aufweisend einen weiteren Träger (15), der auf dem Träger (2) angeordnet ist, wobei die Leuchtdiode (3) auf dem weiteren Träger (15) angeordnet ist.

13. Leuchtdiodenvorrichtung nach dem vorhergehenden Anspruch, wobei der weitere Träger (15) als keramischer Träger ausgebildet ist.

## Claims

1. Light-emitting diode device, comprising at least one carrier (2) and at least one light-emitting diode (3) arranged on the carrier, wherein the carrier (2) comprises a plurality of polymer layers (4, 5, 6) arranged one above another, and wherein an electrical component (7, 17, 18, 19) is embedded into at least one of the polymer layers (4, 5, 6), in which the electrical component (7, 17, 18, 19) is arranged in a centred fashion with respect to the light-emitting diode (3) with respect to a lateral direction,
**characterized in that** the polymer layer (6) into which the electrical component (7, 17, 18, 19) is embedded is more easily mechanically deformable than another of the polymer layers (4, 5).

2. Light-emitting diode device according to the preceding claim, in which the carrier (2) comprises a topmost, a bottommost and at least one inner polymer layer (4, 5, 6) arranged therebetween, wherein the electrical component (7, 17, 18, 19) is embedded at least into the inner polymer layer (6).

3. Light-emitting diode device according to either of the preceding claims, in which the electrical component (7, 17, 18, 19) is surrounded by the polymer material of the carrier (2) on all sides.

4. Light-emitting diode device according to the preceding claim, in which the component (2) is embedded neither into the topmost nor into the bottommost polymer layer (4, 5).

5. Light-emitting diode device according to any of the preceding claims, comprising at least one plated-through hole (10) for electrically contacting the electrical component, wherein the plated-through hole (10) leads through at least one polymer layer (4, 5, 6).

6. Light-emitting diode device according to any of the preceding claims, comprising at least two plated-through holes (10) for connecting the electrical component (7, 17, 18, 19) to connection contacts (11) and comprising at least two further plated-through holes (13) for connecting the light-emitting diode (3) to the connection contacts (11), wherein the at least two plated-through holes (10) are arranged between the at least two further plated-through holes (13).

7. Light-emitting diode device according to any of the preceding claims, in which the electrical component (7, 18) is designed for protection against electrostatic discharges.

8. Light-emitting diode device according to any of the preceding claims, in which the electrical component (7, 17, 18) is designed as a varistor, as a silicon semiconductor protective diode, as a polymer component, as a thermal sensor, as overcurrent protection, as a ceramic multilayer capacitor, as an inductance, as a resistance or as a driver chip.

9. Light-emitting diode device according to any of the preceding claims, in which the light-emitting diode (3) is at least partly recessed in a cavity in the carrier (2) .

10. Light-emitting diode device according to any of the preceding claims, in which the electrical component (7, 17, 18, 19) is arranged in a centred fashion in the carrier (2) with respect to a stacking direction of the polymer layers (4, 5, 6) .

11. Light-emitting diode device according to any of the preceding claims, comprising a plurality of light-emitting diodes (3) arranged on the carrier (2).

12. Light-emitting diode device according to any of the preceding claims, comprising a further carrier (15), which is arranged on the carrier (2), wherein the light-emitting diode (3) is arranged on the further carrier (15) .

13. Light-emitting diode device according to the preceding claim, wherein the further carrier (15) is designed as a ceramic carrier.

## Revendications

1. Dispositif à diodes électroluminescentes, comprenant au moins un support (2) et au moins une diode électroluminescente (3) disposée sur le support, dans lequel le support (2) comprend plusieurs couches polymères (4, 5, 6) superposées et dans lequel un composant électrique (7, 17, 18, 19) est incorporé dans au moins l'une des couches polymères (4, 5, 6), dans lequel le composant électrique (7, 17, 18, 19) est disposé de manière centrée par rapport à une direction latérale et par rapport à la diode électroluminescente (3) ,
**caractérisé en ce que** la couche polymère (6) dans laquelle est incorporé le composant électrique (7, 17, 18, 19) est plus facilement déformable mécaniquement qu'une autre des couches polymères (4, 5).

2. Dispositif à diodes électroluminescentes selon la revendication précédente, dans lequel le support (2) comporte une couche polymère supérieure, une couche polymère inférieure et au moins une couche polymère interne (4, 5, 6) disposée entre celles-ci, dans lequel le composant électrique (7, 17, 18, 19) est incorporé au moins dans la couche polymère interne (6).

3. Dispositif à diodes électroluminescentes selon l'une des revendications précédentes, dans lequel le composant électrique (7, 17, 18, 19) est entouré de tous côtés par le matériau polymère du support (2).

4. Dispositif à diodes électroluminescentes selon la revendication précédente, dans lequel le composant (2) n'est incorporé ni dans la couche polymère supérieure ni dans la couche polymère inférieure (4, 5).

5. Dispositif à diodes électroluminescentes selon l'une des revendications précédentes, comprenant au moins un trou métallisé (10) pour la mise en contact électrique avec le composant électrique, dans lequel le trou métallisé (10) passe à travers au moins une couche polymère (4, 5, 6).

6. Dispositif à diodes électroluminescentes selon l'une des revendications précédentes, comprenant au moins deux trous métallisés (10) pour le raccordement du composant électrique (7, 17, 18, 19) à des contacts de raccordement (11) et comportant au moins deux autres trous métallisés (13) pour le raccordement de la diode électroluminescente (3) aux contacts de raccordement (11), dans lequel lesdits au moins deux trous métallisés (10) sont disposés entre lesdits au moins deux autres trous métallisés (13).

7. Dispositif à diodes électroluminescentes selon l'une des revendications précédentes, dans lequel le composant électrique (7, 18) est conçu pour la protection contre les décharges électrostatiques.

8. Dispositif à diodes électroluminescentes selon l'une des revendications précédentes, dans lequel le composant électrique (7, 17, 18) est réalisé sous forme de varistance, de diode de protection à semi-conducteur en silicium, de composant polymère, de capteur thermique, de protection contre les surintensités, de condensateur multicouche céramique, d'inductance, de résistance ou de puce d'attaque.

9. Dispositif à diodes électroluminescentes selon l'une des revendications précédentes, dans lequel la diode électroluminescente (3) est au moins partiellement encastrée dans une cavité ménagée dans le support (2).

10. Dispositif à diodes électroluminescentes selon l'une des revendications précédentes, dans lequel le composant électrique (7, 17, 18, 19) est disposé dans le support (2) de manière centrée par rapport à une direction d'empilement des couches polymères (4, 5, 6).

11. Dispositif à diodes électroluminescentes selon l'une des revendications précédentes, comprenant une pluralité de diodes électroluminescentes (3) disposées sur le support (2).

12. Dispositif à diodes électroluminescentes selon l'une des revendications précédentes, comprenant un autre support (15) qui est disposé sur le support (2), dans lequel la diode électroluminescente (3) est disposée sur l'autre support (15).

13. Dispositif à diodes électroluminescentes selon la revendication précédente, dans lequel l'autre support (15) est réalisé sous forme de support céramique.
